(19) Europäisches Patentamt
European Patent Office
Office européen des brevets

(11) **EP 1 804 380 B1**

(12) **EUROPÄISCHE PATENTSCHRIFT**

(45) Veröffentlichungstag und Bekanntmachung des Hinweises auf die Patenterteilung:
**13.02.2013 Patentblatt 2013/07**

(51) Int Cl.:
**H03H 17/02** *(2006.01)*　　**H04B 1/30** *(2006.01)*

(21) Anmeldenummer: **06124412.5**

(22) Anmeldetag: **20.11.2006**

(54) **Verfahren und Vorrichtung zur echtzeitfähigen Rekonstruktion eines nicht-äquidistant abgetasteten, analogen Signals**

Method and apparatus for realtime reconstruction of a nonuniformly sampled analogue signal

Procédé et dispositif pour reconstruction en temps réel d'un signal analogique non uniformement echantillonné

(84) Benannte Vertragsstaaten:
**DE FR GB IT**

(30) Priorität: **20.12.2005  DE 102005060874**

(43) Veröffentlichungstag der Anmeldung:
**04.07.2007  Patentblatt 2007/27**

(73) Patentinhaber: **ROBERT BOSCH GMBH**
**70442 Stuttgart (DE)**

(72) Erfinder: **Wenzler, Axel**
**71229 Leonberg (DE)**

(56) Entgegenhaltungen:
WO-A-02/29806　　　DE-A1- 10 124 660
US-A1- 2004 042 557　　US-B1- 6 757 343

- **WENZLER, SELINGER: "Robust reconstruction of nonuniformly sampled signals" IEEE, Bd. 1, 2. September 2005 (2005-09-02), XP002424027**
- **YONINA C ELDAR ET AL: "Filterbank Reconstruction of Bandlimited Signals from Nonuniform and Generalized Samples" IEEE TRANSACTIONS ON SIGNAL PROCESSING, IEEE SERVICE CENTER, NEW YORK, NY, US, Bd. 48, Nr. 10, Oktober 2000 (2000-10), XP011059116 ISSN: 1053-587X**
- **KOILPILLAI R D ET AL: "COSINE-MODULATED FIR FILTER BANKS SATISFYING PERFECT RECONSTRUCTION" IEEE TRANSACTIONS ON SIGNAL PROCESSING, IEEE SERVICE CENTER, NEW YORK, NY, US, Bd. 40, Nr. 4, 1. April 1992 (1992-04-01), Seiten 770-783, XP000301406 ISSN: 1053-587X**
- **VOLKMAR SAUERLAND: "Mathematische Optimierung im Entwurf cosinus-modulierter Filterbänke" INTERNET ARTICLE, [Online] 2003, Seiten 1-81, XP002424091 Gefunden im Internet: URL:http://www.numerik.uni-kiel.de/~vsa/vs diplom.pdf> [gefunden am 2007-03-01]**
- **FEICHTINGER H G ET AL: "EFFICIENT NUMERICAL METHODS IN NON-UNIFORM SAMPLING THEORY" NUMERISCHE MATHEMATIK, SPRINGER VERLAG, BERLIN,, DE, Bd. 69, Nr. 4, 1995, Seiten 423-440, XP001148327 ISSN: 0029-599X**

EP 1 804 380 B1

EP 1 804 380 B1

**Beschreibung**

Stand der Technik

Die vorliegende Erfindung betrifft ein Verfahren und eine Vorrichtung zur Rekonstruktion eines nicht-äquidistant abgetasteten, analogen Signals.

In der Nachrichtentechnik wird die Abtastung von analogen Signalen in der Regel zu äquidistanten Abtastzeitpunkten mit einer konstanten Abtastrate bzw. Abtastfrequenz durchgeführt. Dabei gilt das Abtasttheorem, auch erste Nyquist-Bedingung genannt, welches den (im Sinne von Information) verlustfreien Übergang von wert- und zeitkontinuierlichen Signalen zu wertkontinuierlichen zeitdiskreten Signalen gewährleistet. Das Abtasttheorem besagt, dass Signale genau dann exakt rekonstruiert werden können, wenn die im Signal enthaltenen Frequenzen maximal halb so groß wie die verwendete Abtastrate bzw. Abtastfrequenz sind. Wird die Abtastbedingung verletzt, d.h. das Signal weist Anteile mit größeren Frequenzen als die halbe Abtastrate auf, so entstehen Störungen, so genannte Überlappungsfehler (Aliasing). Dabei werden hohe Frequenzanteile zu tiefen Frequenzen hin verschoben und verfälschen so das rekonstruierte Signal. Eine exakte Rekonstruktion des übertragenen Signals ist daher nicht mehr möglich.

Zum Beispiel in Multiplexsystemen, insbesondere in Zeitmultiplexsystemen, d.h. in Systemen, bei denen zwei oder mehrere Signale abwechselnd übertragen bzw. empfangen werden, treten Signale auf, die nur zu zeitlich begrenzten und periodisch wiederkehrenden Zeitschlitzen beobachtbar sind. Aufgrund des Multiplexens des analogen Signals entsteht zwangsläufig Aliasing, d.h. es treten Störungen bei der Rekonstruktion des Signals auf, sofern das analoge Signal Frequenzen enthält, die höher als die halbe Multiplexrate sind. Soll das analoge Signal fehlerfrei rekonstruiert werden, so sind innerhalb eines Beobachtungszeitraums bzw. einer Multiplexperiode mehrere Abtastwerte aufzunehmen. Das Aufnehmen von mehreren Abtastwerten pro Beobachtungszeitraum führt zu einer nicht-äquidistanten Abtastung des analogen Signals.

Aus der Theorie ist bekannt, dass ein nicht-äquidistant abgetastetes Signal theoretisch unter Verwendung von speziellen Rekonstruktionsfunktionen ebenso vollständig wie bei einer Abtastung, bei der die Abtastbedingung eingehalten worden ist, wiederhergestellt werden kann. Die zur Rekonstruktion zu verwendenden, speziellen Rekonstruktionsfunktionen sind zeitlich unendlich ausgedehnt und zeigen zudem im Allgemeinen sehr große Amplitudenwerte. Die sehr großen Amplitudenwerte führen bei der praktischen Umsetzung sowohl zu numerischen Instabilitäten als auch zu einer überproportionalen Verstärkung des Rauschens. Aus diesen Gründen ist die ideale Rekonstruktion des analogen Signals mittels der speziellen Rekonstruktionsfunktionen praktisch kaum einsetzbar.

Dieses Problem wird im Wesentlichen von der von der Anmelderin angemeldeten Patentanmeldung (R.309957) mit dem Titel "Verfahren zur Rekonstruktion eines nicht-äquidistant abgetasteten, analogen Signals" gelöst. Bei dem angemeldeten Verfahren zur Rekonstruktion eines nicht-äquidistant abgetasteten, analogen Signals wird ein Funktionsansatz mit endlich ausgedehnten Funktionen eingesetzt. Die Parameter dieses Funktionsansatzes werden dabei mit Hilfe eines Kleinste-Fehlerquadrate-Ansatzes bestimmt. Allerdings führt der Einsatz der Approximationsmatrix und der Rekonstruktionsmatrix auf eine Blockverarbeitung zur Bereitstellung der Rekonstruktionswerte. Allerdings wachsen im Falle der Blockverarbeitung der Speicherbedarf, insbesondere für die Approximationsmatrix und die Rekonstruktionsmatrix, und der Rechenaufwand quadratisch mit der Verarbeitungslänge.

In YONINA C ELDAR ET AL: "Filterbank Reconstruction of Bandlimited Signals from Nonuniform and Generalized Samples" IEEE TRANSACTIONS ON SIGNAL PROCESSING, IEEE SERVICE CENTER, NEW YORK, NY, US, Bd. 48, Nr. 10, Oktober 2000 (2000-10), XP011059116 ISSN; werden Filterbankrekonstruktrionen von bandbegrenzten Signalen, durch nicht uniforme und allgemeine Abtastungen beschrieben.

Die Merkmale des Oberbegriffs der unabhängigen Ansprüche sind in WENZLER, SELINGER: "Robust reconstruction of nonuniformly sampled signals" IEEE, Bd. 1, 2. September 2005 (2005-09-02), XP002424027; beschrieben.

Vorteile des Erfindung

Das erfindungsgemäße Verfahren bzw. die erfindungsgemäße Vorrichtung zur echtzeitfähigen Rekonstruktion eines nicht-äquidistant abgetasteten, analogen Signals mit den Merkmalen des Anspruchs 1 bzw. des Anspruchs 12 weist den Vorteil auf, aufgrund des Ersatzes aufwändiger Matrixmultiplikationen durch einfache Filteroperationen echtzeitfähig zu sein. Folglich können unendlich lange Signale verarbeitet werden. Unabhängig von der Länge, des zu verarbeitenden Signals bleibt der Speicherbedarf für die jeweiligen Filterfunktionen konstant und der Rechenaufwand steigt nur linear mit der Verarbeitungslänge. Des Weiteren ist das nur zu begrenzten, periodisch wiederkehrenden Zeiten beobachtbare analoge Signal robust rekonstruierbar, wobei das analoge Signal Frequenzen aufweisen kann, die höher als die halbe Multiplexrate sind. Ein weiterer Vorteil ist, dass das erfindungsgemäße Verfahren numerisch stabil ist, da die großen Amplituden, welche bei der Verwendung herkömmlicher Rekonstruktionsfunktionen auftreten können, vermieden werden.

Die der Erfindung zugrunde liegende Idee besteht im Wesentlichen darin, ein Verfahren mit den folgenden Schritten zur echtzeitfähigen Rekonstruktion eines nicht-äquidistant abgetasteten, analogen Signals bereitzustellen, welches nur zu begrenzten, periodisch wiederkehrenden Zeitintervallen beobachtbar ist:

a) Bereitstellen einer Anzahl K an vorbestimmten Approximationsfunktionen, mit $k \in [0,...,K-1]$, für jeweils einen vorbestimmten Abtastzeitpunkt, wobei in jedem Zeitintervall eine Anzahl M an vorbestimmten Abtastzeitpunkten vorgesehen wird;

b) nicht-äquidistantes Abtasten des Signals an den vorbestimmten Abtastzeitpunkten zur Ausbildung einer Abtastwertfolge;

c) Bereitstellen einer Anzahl K an Filterpfaden, wobei jeweils in dem k-ten Filterpfad die folgenden Schritte durchgeführt werden:

c1) Filtern der Abtastwertfolge mittels einer von der k-ten Approximationsfunktion abhängigen k-ten Impulsantwort zur Bereitstellung einer gefilterten Abtastwertfolge, und

c2) Filtern der gefilterten Abtastwertfolge mittels einer k-ten Filterfunktion zur Bereitstellung einer k-ten Filterpfadausgangsfolge, wobei die K Filterfunktionen in Abhängigkeit der K Impulsantworten bestimmt werden; wobei zur Bestimmung der K Filterfunktionen ($f_k(n)$) eine Vielzahl von ersten Hilfsfolgen ($\alpha$) berechnet wird, wobei eine erste Hilfsfolge aus einer Faltung zweier unterschiedlicher oder zweier identischer k-ten Impulsantworten ($h_k(n)$) berechnet wird.

d) Überlagern der K Filterpfadausgangsfolgen zur Ausbildung einer Gewichtungswertfolge; und

e) Filter der Gewichtungswertfolge mittels einer Rekonstruktionsfilterfunktion, welche mittels zumindest einer Approximationsfunktion und einer Anzahl R von Rekonstruktionszeitpunkten bestimmt wird, zur Ausbildung einer Rekonstruktionswertfolge, welche zu jedem vorbestimmten Rekonstruktionszeitpunkt einen Rekonstruktionswert aufweist.

Des Weiteren ist erfindungsgemäß eine Vorrichtung zur Durchführung des obigen Verfahrens vorgesehen, welche aufweist:

a) erste Mittel, welche eine Anzahl K an vorbestimmten Approximationsfunktionen, mit $k \in [0,...,K-1]$, für jeweils einen vorbestimmten Abtastzeitpunkt bereitstellen, wobei in jedem Zeitintervall eine Anzahl M an vorbestimmten Abtastzeitpunkten vorgesehen ist;

b) eine Abtastvorrichtung, welche das Signal an den vorbestimmten Abtastzeitpunkten zur Ausbildung einer Abtastwertfolge abtastet;

c) eine Anzahl K von Filterpfaden, wobei jeweils der k-te Filterpfad aufweist:

c1) eine erste Filtervorrichtung, welche die Abtastwertfolge mittels einer von der k-ten Approximationsfunktion abhängigen k-ten Impulsantwort zur Bereitstellung einer gefilterten Abtastwertfolge filtert; und

c2) eine zweite Filtervorrichtung, welche die gefilterte Abtastwertfolge mittels einer k-ten Filterfunktion zur Bereitstellung einer k-ten Filterpfadausgangsfolge filtert, wobei die K Filterfunktionen in Abhängigkeit der K Impulsantworten bestimmt sind; wobei zur Bestimmung der K Filterfunktionen ($f_k(n)$) eine Vielzahl von ersten Hilfsfolgen ($\alpha$) berechnet wird, wobei eine erste Hilfsfolge ($\alpha$) aus einer Faltung zweier unterschiedlicher oder zweier identischer k-ten Impulsantworten ($h_k(n)$) berechnet wird.

d) eine Überlagerungsvorrichtung, welche die K Filterpfadausgangsfolgen zur Ausbildung einer Gewichtungswertfolge überlagert; und

e) eine Rekonstruktionsfiltervorrichtung, welche die Gewichtungswertfolge mittels einer Rekonstruktionsfilterfunktion, welche mittels zumindest einer Approximationsfunktion und einer Anzahl R von Rekonstruktionszeitpunkten bestimmt wird, zur Ausbildung einer Rekonstruktionswertfolge, welche zu jedem vorbestimmten Rekonstruktionszeitpunkt einen Rekonstruktionswert aufweist, filtert.

In den Unteransprüchen finden sich vorteilhafte Weiterbildungen und Ausgestaltungen des in Anspruch 1 angegebenen Verfahrens und der in Anspruch 13 angegebenen Vorrichtung zur echtzeitfähigen Rekonstruktion eines nicht-äquidistant abgetasteten analogen Signals.

Gemäß einer bevorzugten Weiterbildung der Erfindung wird eine Vielzahl von zweiten Hilfsfolgen zur Bestimmung der K Filterfünktionen bestimmt, wobei eine zweite Hilfsfolge in Abhängigkeit des Faktors M und zumindest einer ersten Hilfsfolge bestimmt wird.

Gemäß einer weiteren bevorzugten Weiterbildung werden die K Filterfunktionen mittels eines Perfekte-Rekonstruktion-Verfahrens aus den zweiten Hilfsfolgen bestimmt.

Gemäß einer weiteren bevorzugten Weiterbildung wird das Perfekte-Rekonstruktion-Verfahren mittels einer Toleranzfunktion mit einem vorbestimmten Toleranzbereich versehen.

Gemäß einer weiteren bevorzugten Weiterbildung ist die Rekonstruktionsfilterfunktion als eine Tiefpass-Filterfunktion ausgebildet.

Gemäß einer weiteren bevorzugten Weiterbildung werden die Filterfunktionen jeweils in einen ersten Teil, der für die jeweilige Filterfunktion spezifisch ist, und in einen zweiten Teil, den alle Filterfunktionen aufweisen, aufgeteilt.

Gemäß einer weiteren bevorzugten Weiterbildung wird eine Gesamttiefpass-Filterfunktion mittels einer Faltung aus der Tiefpass-Filterfunktion und dem zweiten Teil der Filterfunktionen bereitgestellt.

Gemäß einer weiteren bevorzugten Weiterbildung werden der erste Teil, der zweite Teil und die Gesamttiefpass-Filterfünktion jeweils in eine Anzahl N ihrer Polyphasenkomponenten aufgeteilt.

Gemäß einer weiteren bevorzugten Weiterbildung werden zwischen dem Filtern mittels der k-ten Impulsantwort und dem Filtern mittels der k-ten Filterfunktion folgende Schritte durchgeführt:

- Dezimieren einer Rate der gefilterten Abtastwertfolge um den Faktor M; und

- Erhöhen der Rate der gefilterten Abtastwertfolge um den Faktor K.

Gemäß einer weiteren bevorzugten Weiterbildung wird die Approximationsfunktion als B-Splines, als eine hermitesche Funktion oder als eine von einer Si-Funktion abgeleiteten Funktion ausgebildet.

Gemäß einer weiteren bevorzugten Weiterbildung werden die Abtastzeitpunkte innerhalb eines Zeitintervalls und/oder die Rekonstruktionszeitpunkte äquidistant gewählt.

Gemäß einer bevorzugten Ausgestaltung der Erfindung weist die zweite Filtervorrichtung eine Anzahl N an Filtereinheiten auf, wobei die jeweilige n-te Filtereinheit, mit $n \in [0,...,N-1]$, die gefilterte Abtastwertfolge mittels der n-ten Polyphasenkomponente des ersten Teils filtert.

Gemäß einer weiteren bevorzugten Ausgestaltung weist die Rekonstruktionsfiltervorrichtung die Anzahl N an Rekonstruktionsfiltereinheiten auf, wobei die jeweilige n-te Rekonstruktionsfiltereinheit die Ausgänge der n-ten Filtereinheiten mittels der n-ten Polyphasenkomponenten der Gesamttiefpass-Filterfunktion filtert.

Gemäß einer weiteren bevorzugten Ausgestaltung weist die n-te Rekonstruktionsfiltereinheit ein vorgeschaltetes Zeitglied auf, welches die Filterung mittels der n-ten Polyphasenkomponente der Gesamttiefpass-Filterfunktion um n Zeiteinheiten verzögert.

Gemäß einer weiteren bevorzugten Ausgestaltung weist der k-te Filterpfad eine Dezimationsfiltereinheit und eine Interpolationsfiltereinheit auf, wobei die Dezimationsfiltereinheit die Rate der gefilterten Abtastwertfolge um den Faktor M dezimiert und die Interpolationsfiltereinheit die Rate der gefilterten Abtastwertfolge um den Faktor K erhöht.

Zeichnungen

Ausführungsbeispiele der Erfindung sind in den Zeichnungen dargestellt und in der nachfolgenden Beschreibung näher erläutert. Es zeigen:

Fig. 1    ein schematisches Ablaufdiagramm eines ersten Ausführungsbeispiels des erfindungsgemäßen Verfahrens;

Fig. 2    ein schematisches Ablaufdiagramm eines zweiten Ausführungsbeispiels des erfindungsgemäßen Verfahrens;

Fig. 3    ein Diagramm zur Darstellung eines Ausführungsbeispiels einer Approximationsfunktion;

Fig. 4    ein schematisches Blockschaltbild eines ersten Ausführungsbeispiels der erfindungsgemäßen Vorrichtung;

Fig. 5    ein schematisches Blockschaltbild eines zweiten Ausführungsbeispiels der erfindungsgemäßen Vorrichtung; und

Fig. 6    ein schematisches Blockschaltbild eines dritten Ausführungsbeispiels der erfindungsgemäßen Vorrichtung.

Beschreibung der Ausführungsbeispiele

In den Figuren bezeichnen gleiche Bezugszeichen gleiche oder funktionsgleiche Bestandteile.

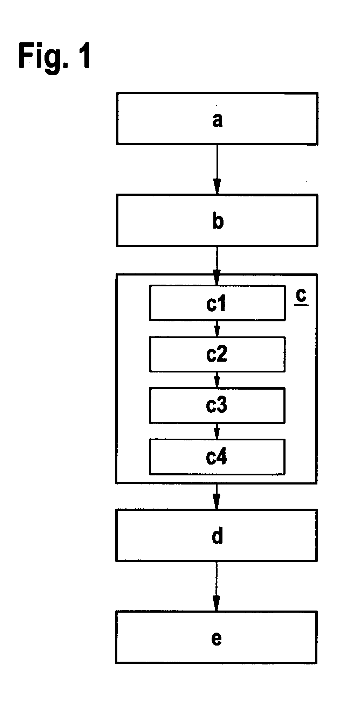

In Fig. 1 ist ein schematisches Ablaufdiagramm eines ersten Ausführungsbeispiels des erfindungsgemäßen Verfahrens zur echtzeitfähigen Rekonstruktion eines nicht-äquidistant abgetasteten, analogen Signals s(t), welches nur zu begrenzten, periodisch mit der Periodendauer $T_M$ wiederkehrenden Zeitintervallen beobachtbar ist, dargestellt.

Zur Veranschaulichung der vorliegenden Erfindung wird auf die angemeldete Patentanmeldung "Verfahren zur Rekonstruktion eines nicht-äquidistant abgetasteten, analogen Signals" der Anmelderin Bezug genommen. Dabei werden die nicht-äquidistant aufgenommenen Messwerte $s_i$ von $N_{TM}$ Perioden $T_M$ oder Zeitintervallen mit Hilfe mehrerer Matrixmultiplikationen in $N_a$ Parameter $a_i$ mittels einer Blockverarbeitung umgerechnet:

$$\underline{a} = (\Theta^T \cdot \Theta)^{-1} \cdot \Theta^T \cdot \underline{s} \qquad (1)$$

wobei die Abtastwerte $s_i$ zum Vektor $\underline{s}$, mit $N_S = N_{TM}*M$ Einträgen bei M Abtastwerten pro Periode $T_M$,

$$\underline{s} = \begin{bmatrix} s_0 \\ s_1 \\ \vdots \\ s_{N_s - 1} \end{bmatrix} \qquad (2)$$

und die Parameter $a_i$ zum Vektor $\underline{a}$

$$\underline{a} = \begin{bmatrix} a_0 \\ a_1 \\ \vdots \\ a_{N-1} \end{bmatrix} \qquad (3)$$

zusammengefasst sind. Der Vektor $\underline{a}$ hat $N_a < N_s$ Einträge.

Die Parameter $a_i$ des Gewichtungsvektors beschreiben die zu rekonstruierende Zeitfunktion z(t) mit Hilfe des Funktionsansatzes:

$$z(t) = \hat{z}(\underline{a}, t) = \sum_{n=0}^{N-1} a_n \cdot \varphi_n(t) \qquad (4)$$

Die Berechnung der Parameter $a_i$ nach Formel (1) entspricht der im Sinne des kleinsten Fehlerquadrats optimalen Lösung. Dabei werden die in Formel (5) dargestellten Rekonstruktionsfunktionen $\varphi_n(t)$ der Approximationsmatrix $\Theta$ eingesetzt:

$$\Theta = \begin{bmatrix} \varphi_0(t_0) & \varphi_k(t_0) & \cdots & \varphi_{N-1}(t_0) \\ \varphi_0(t_1) & \varphi_1(t_1) & \cdots & \varphi_{N-1}(t_1) \\ \vdots & \vdots & \vdots & \vdots \\ \varphi_0(t_{NS-1}) & \varphi_1(t_{NS-1}) & \cdots & \varphi_{N-1}(t_{NS-1}) \end{bmatrix} \qquad (5)$$

Die oben stehende Approximationsmatrix $\Theta$ enthält die Approximationsfunktionen $\varphi_k$ an den Abtastzeitpunkten t, mit t= [0,...,$N_S$]. Aus den so gewonnenen Parametern wird mit Hilfe einer weiteren Matrixmultiplikation ein Vektor $\underline{z}$ bestimmt, der die Zeitfunktion an gewünschten Rekonstruktionszeitpunkten enthält:

$$\underline{z} = \tilde{\Theta} \cdot \underline{a} \qquad (6)$$

Oben stehendes ist der angemeldeten Patentanmeldung der Anmelderin entnommen und dient zur Veranschaulichung der vorliegenden Erfindung.

Nachfolgend wird das erfindungsgemäße Verfahren anhand des Blockschaltbilds in Fig. 1 erläutert. Das erfindungsgemäße Verfahren weist die folgenden Verfahrensschritte auf:

Verfahrensschritt a:

Eine Anzahl K an vorbestimmten Approximationsfunktionen $\varphi_k$, mit $k \in [0,...,K-1]$, wird für jeweils vorbestimmte Abtastzeitpunkte t bereitgestellt, wobei in jedem Zeitintervall $T_M$ eine Anzahl M an vorbestimmten Abtastzeitpunkten t vorgesehen wird. Bei der vorliegenden Erfindung werden demnach K Approximationsfunktionen $\varphi_k$ pro Zeitintervall $T_M$ verwendet. Dabei wird ausgenutzt, dass sich die einzelnen Approximationsfunktionen $\varphi_k$ mittels der in Formel (7) abgebildeten Vorschrift durch Zeitverschiebung ineinander überführen lassen:

$$\varphi_{m+1}(t) = \varphi_m(t - T_M/K) \qquad (7)$$

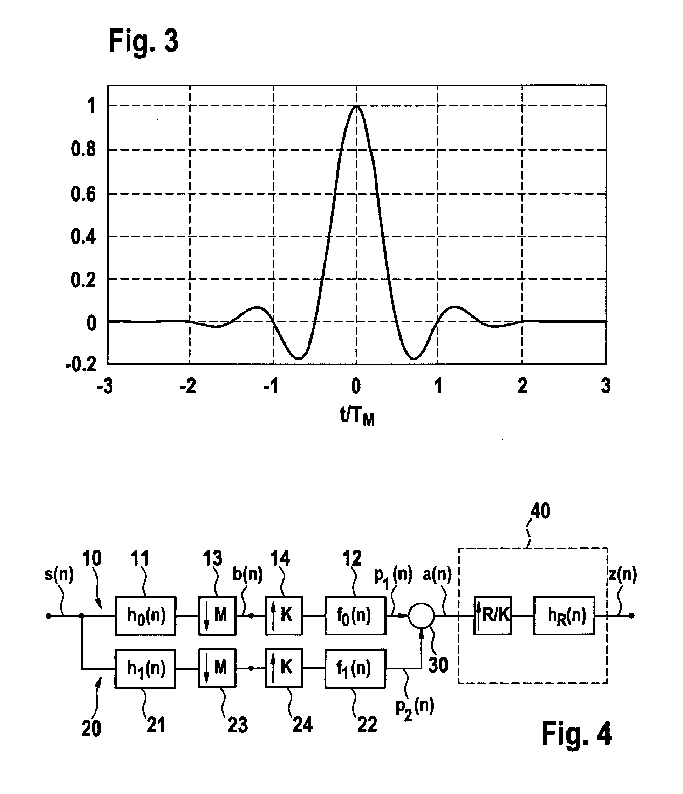

Vorzugsweise wird die Approximationsfunktion $\varphi_k$ als B-Splines, als eine hermitesche Funktion oder als eine von einer Si-Funktion abgeleiteten Funktion ausgebildet. Dabei zeigt Fig. 3 ein Beispiel einer Approximationsfunktion $\varphi_k$, nämlich eine gefensterte Si-Funktion. Vorzugsweise ist die als Si-Funktion ausgebildete Approximationsfunktion $\varphi_k$ auf ein vorbestimmtes Zeitfenster W gefenstert. Dabei zeigt die X-Achse des Diagramms gemäß Fig. 3 eine auf das Zeitintervall $T_M$ normierte Zeitachse t. Beispielsweise beträgt das Fenster W fünf normierte Zeiteinheiten, von -2,5 $t/T_M$ bis +2,5$t/T_M$ (W = 5).

Verfahrensschritt b:

Das Signal s(t) wird an den vorbestimmten Abtastzeitpunkten t zur Ausbildung einer Abtastwertfolge s(n) nicht-äquidistant abgetastet.

Verfahrensschritt c:

Es wird eine Anzahl K an Filterpfaden 10, 20 bereitgestellt, wobei jeweils in dem k-ten Filterpfad 10, 20 die folgenden Verfahrensschritte c1 und c2 durchgeführt werden:

Verfahrensschritt c1:

Die Abtastwertfolge s(n) wird mittels einer von der k-ten Approximationsfunktion $\varphi_k$ abhängigen k-ten Impulsantwort $h_k(n)$ zur Bereitstellung einer gefilterten Abtastwertfolge $b_k(n)$ gefiltert. Ist beispielsweise K = 2, ergeben sich unten stehende, in Formel (8a) abgebildete Impulsantworten $h_0(n)$ und $h_1(n)$:

$$h_0(n) = ...,\varphi_0(t_6),\varphi_0(t_5),\varphi_0(t_4),\varphi_0(t_3),\varphi_0(t_2),\varphi_0(t_1),\varphi_0(t_0)$$

$$(8a)$$

$$h_1(n) = ...,\varphi_1(t_6),\varphi_1(t_5),\varphi_1(t_4),\varphi_1(t_3),\varphi_1(t_2),\varphi_1(t_1),\varphi_1(t_0)$$

Die zu verwendenden Filterfunktionen, hier $h_0(n)$ und $h_1(n)$, werden direkt aus den Approximationsfunktionen $\varphi_k$, mit $k \in [0,...,K-1]$, abgeleitet. Die Anzahl der Filterkoeffizienten der Impulsantworten in Formel (8a) ergibt sich aus der Fensterung W der entsprechenden Approximationsfunktion $\varphi_k$. Hat beispielsweise die gefensterte Approximationsfunktion eine Länge von $W \cdot T_M$, so besitzen die Impulsantworten $h_0(n)$ und $h_1(n)$ in der Formel (8a) $W \cdot M$ Einträge. Sind beispielsweise gemäß Fig. 3 W = 5 und M = 6 gewählt, so ergeben sich für die Impulsantworten $h_0(n)$ und $h_1(n)$ 30 Einträge.

Verfahrensschritt c2:

Die gefilterte Abtastwertfolge $b_k(n)$ wird mittels einer k-ten Filterfunktion $f_k(n)$ zur Bereitstellung einer k-ten Filterpfadausgangsfolge $p_k(n)$ gefiltert, wobei die K Filterfunktionen $f_k(n)$ in Abhängigkeit der K Impulsantworten $h_k(n)$ bestimmt werden.

Vorzugsweise wird eine Vielzahl von ersten Hilfsfolgen $\alpha$ zur Bestimmung der K Filterfunktionen $f_k(n)$ berechnet, wobei eine erste Hilfsfolge $\alpha$ aus einer Faltung zwei unterschiedlicher oder zwei identischer k-ten Impulsantworten $h_k(n)$ berechnet wird. Ohne Einschränkung der Allgemeinheit wird zur folgenden Veranschaulichung der Erfindung K = 2 gewählt. Somit ergeben sich folgende erste Hilfsfolgen $\alpha_{00}(n)$, $\alpha_{01}(n)$ und $\alpha_{11}(n)$ aus den beiden Impulsantworten $h_0(n)$ und $h_1(n)$:

$$\alpha_{00}(n) = h_0(n)*h_0(n) \qquad\qquad\qquad (9)$$

$$\alpha_{01}(n) = h_0(n)*h_1(n)$$

$$\alpha_{11}(n) = h_1(n)*h_1(n)$$

Der Operator "*" bezeichnet dabei die Faltungsoperation. Zur weiteren Bestimmung der K Filterfunktionen $f_k(n)$ wird eine Vielzahl von zweiten Hilfsfolgen $g(n)$ bestimmt, wobei eine zweite Hilfsfolge $g(n)$ in Abhängigkeit des Faktors M und zumindest einer ersten Hilfsfolge $\alpha(n)$ bestimmt wird. Für das Beispiel K = 2 ergeben sich unten stehende zwei zweiten Hilfsfolgen $g_0(n)$ und $g_1(n)$:

$$g_0(n) = \begin{cases} \alpha_{00}(M \cdot n + n_0) & ; n\ gerade \\ \alpha_{01}(M \cdot (n-1) + n_0) & ; n\ ungerade \end{cases} \qquad (10)$$

$$g_1(n) = \begin{cases} \alpha_{01}(M \cdot n + n_0) & ; n\ gerade \\ \alpha_{11}(M \cdot (n-1) + n_0) & ; n\ ungerade \end{cases}$$

Hierzu ist zu bemerken, dass für den Parameter $n_0$ vorzugsweise der Wert M-1 gewählt wird.

Vorzugsweise werden die K Filterfunktionen $f_k(n)$ mittels eines Perfekte-Rekonstruktion-Verfahrens aus den zweiten Hilfsfolgen $g(n)$ bestimmt. Für das Beispiel K = 2 sind damit die beiden Filterfunktionen $f_0(n)$ und $f_1(n)$ nun so zu bestimmen, dass die unten stehende Bedingung in nächster Näherung erfüllt ist.

$$f_0(n)*a(n) = 2\cdot(-1)^n\cdot g_1(n) \qquad\qquad\qquad (11)$$

$$f_1(n)*a(n) = -2\cdot(-1)^n\cdot g_0(n)$$

$$\text{mit}$$

$$a(n) = g_0(n)*\left((-1)^n \cdot g_1(n)\right) - \left((-1)^n \cdot g_0(n)\right)*g_1(n)$$

Zur perfekten Rekonstruktion wird auf Norbert Fliege, "Multiraten-Signalverarbeitung: Theorie und Anwendungen", Stuttgart, Teubner Verlag, 1993, verwiesen. Die exakte Erfüllung der Bedingung in Formel (11) führt allerdings in der Regel auf unendlich ausgedehnte und nicht kausale Impulsantworten $f_0(n)$ und $f_1(n)$. Durch eine Beschränkung auf endlich viele Werte und eine Indexverschiebung werden realisierbare Impulsantworten $f_0(n)$ und $f_1(n)$ erhalten. Vorzugsweise wird das Perfekte-Rekonstruktion-Verfahren mittels einer Toleranzfunktion $h_{Filter}(n)$ mit einem vorbestimmten Toleranzbereich versehen. Dann wird die Bedingung in der Formel (11) durch die unten stehende Bedingung der Formel (12) ersetzt:

$$f_0(n){*}a(n) = 2 \cdot (-1)^n \cdot g_1(n){*}h_{Filter}(n) \qquad\qquad (12)$$
$$f_1(n){*}a(n) = -2 \cdot (-1)^n \cdot g_0(n){*}h_{Filter}(n)$$

Verfahrensschritt d:

Die K Filterpfadausgangsfolgen $p_k(n)$ werden zur Ausbildung einer Gewichtungswertfolge a(n) überlagert.

Verfahrensschritt e:

Die Gewichtungswertfolge a(n) wird mittels einer Rekonstruktionsfilterfunktion $h_R(n)$, welche mittels zumindest einer Approximationsfunktion $\varphi_k$ und einer Anzahl R von Rekonstruktionszeitpunkten $t_R$ bestimmt wird, zur Ausbildung einer Rekonstruktionswertfolge z(n) gefiltert, welche zu jedem vorbestimmten Rekonstruktionszeitpunkt $t_R$ einen Rekonstruktionswert aufweist. Oben stehendes Beispiel aufgreifend, mit K = 2, ergibt sich für die Rekonstruktionsfilterfunktion $h_R(n)$:

$$h_0(n) = ...,\varphi_0(t_{R6}),\varphi_0(t_{R5}),\varphi_0(t_{R4}),\varphi_0(t_{R3}),\varphi_0(t_{R2}),\varphi_0(t_{R1}),\varphi_0(t_{R0}) \qquad\qquad (8b)$$

Vorzugsweise werden die Abtastzeitpunkte t innerhalb eines Zeitintervalls oder einer Periode $T_M$ und/oder die Rekonstruktionszeitpunkte $t_R$ äquidistant gewählt.

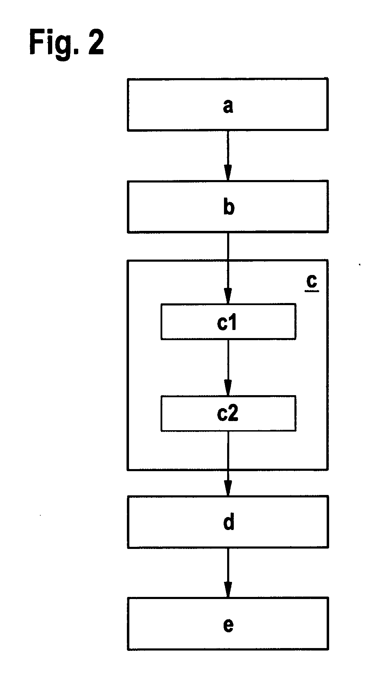

In Fig. 2 ist ein schematisches Ablaufdiagramm eines zweiten Ausführungsbeispiels des erfindungsgemäßen Verfahrens dargestellt. Die Verfahrensschritte a, b, d und e gemäß Fig. 2 entsprechen den jeweiligen Verfahrensschritten a, b, d und e gemäß Fig. 1. Gemäß dem Blockschaltbild in Fig. 2 weist der Verfahrensschritt c die folgenden Verfahrensteilschritte c1, c2, c3 und c4 auf:

Verfahrensschritt c1:

Die Abtastwertfolge s(n) wird mittels einer von der k-ten Approximationsfunktion $\varphi_k$ abhängigen k-ten Impulsantwort $h_k(n)$ zur Bereitstellung einer gefilterten Abtastwertfolge gefiltert.

Verfahrensschritt c2:

Die Rate der gefilterten Abtastwertfolge wird um den Faktor M dezimiert.

Verfahrensschritt c3:

Die Rate der gefilterten Abtastwertfolge b(n) wird anschließend um den Faktor K erhöht.

Verfahrensschritt c4:

Die Gewichtungswertfolge wird - wie in dem Ausführungsbeispiel gemäß Fig. 1 beschrieben - mittels der Rekonstruktionsfilterfunktion $h_R(n)$ zur Ausbildung der Rekonstruktionswertfolge z(n) gefiltert.
Fig. 4 zeigt ein schematisches Blockschaltbild eines ersten Ausführungsbeispiels der erfindungsgemäßen Vorrichtung zur Durchführung des Verfahrens zur echtzeitfähigen Rekonstruktion eines nicht-äquidistant abgetasteten analogen Signals s(t), welches nur zu begrenzten, periodisch mit der Periodendauer $T_M$ wiederkehrenden Zeitintervallen beobachtbar ist.
Die erfindungsgemäße Vorrichtung weist erste Mittel (nicht gezeigt) auf, welche eine Anzahl K an vorbestimmten Approximationsfunktionen $\varphi_k$, mit $k \in [0,...,K-1]$, für jeweils einen vorbestimmten Abtastzeitpunkt t bereitstellen, wobei in jedem Zeitintervall $T_M$ eine Anzahl M an vorbestimmten Abtastzeitpunkten t vorgesehen ist.
Außerdem weist die erfindungsgemäße Vorrichtung eine Abtastvorrichtung (nicht gezeigt) auf, welche das Signal s(t) an den vorbestimmten Abtastzeitpunkten t zur Ausbildung einer Abtastwertfolge s(n) abtastet.
Ferner ist eine Anzahl K von Filterpfaden 10, 20 vorgesehen, wobei jeweils der k-te Filterpfad 10, 20 eine erste Filtervorrichtung 11, 21 und eine zweite Vorrichtung 12, 22 aufweist. Ohne Einschränkung der Allgemeinheit ist für die Ausführungsbeispiele gemäß der Fig. 4, 5 und 6 K = 2 gewählt. Demnach weist die erfindungsgemäße Vorrichtung einen ersten Filterpfad 10 und einen zweiten Filterpfad 20 auf.

Die erste Filtervorrichtung 11 des ersten Filterpfades 10 filtert die Abtastwertfolge $s(n)$ mittels der von der 0-ten Approximationsfunktion $\varphi_0$ abhängigen 0-ten Impulsantwort $h_0(n)$, die in Gleichung (8a) dargestellt ist, zur Bereitstellung einer gefilterten Abtastwertfolge. Analoges gilt für die erste Filtervorrichtung 21 des zweiten Filterpfades 20. Demnach filtert die erste Filtervorrichtung 21 des zweiten Filterpfades 20 die Abtastwertfolge $s(n)$ mittels der von der ersten Approximationsfunktion $\varphi_1$ abhängigen ersten Impulsantwort $h_1(n)$ zur Bereitstellung der gefilterten Abtastwertfolge.

Außerdem weisen der erste Filterpfad 10 und der zweite Filterpfad 20 jeweils eine zweite Filtervorrichtung 12, 22 auf, welche die gefilterte Abtastwertfolge $b(n)$ mittels der 0-ten Filterfunktion $f_0(n)$ bzw. der ersten Filterfunktion $f_1(n)$ zur Bereitstellung einer 0-ten Filterpfadausgangsfolge $p_0(n)$ bzw. einer ersten Filterpfadausgangsfolge $p_1(n)$ filtert, wobei die K Filterfunktionen $f_k(n)$, mit $k \in [0,...,K-1]$, in Abhängigkeit der K Impulsantworten $h_k(n)$ bestimmt werden.

Vorzugsweise weisen der erste Filterpfad 10 und der zweite Filterpfad 20 jeweils eine Dezimationseinheit 13, 23 und eine Aufwärtstastereinheit 14, 24 auf, wobei die Dezimationseinheit 13, 23 die Rate der gefilterten Abtastwertfolge um den Faktor M dezimiert und die Aufwärtstastereinheit 14, 24 die Rate der gefilterten Abtastwertfolge $b(n)$ um den Faktor K erhöht.

Ferner ist eine Überlagerungsvorrichtung 30 vorgesehen, welche die K Filterpfadausgangsfolgen $p_k(n)$, hier $p_0(n)$ und $p_1(n)$, zur Ausbildung einer Gewichtungswertfolge $a(n)$ überlagert.

Weiterhin ist eine Rekonstruktionsfiltervorrichtung 40 vorgesehen, welche die Gewichtungswertfolge $a(n)$ mittels einer Rekonstruktionsfilterfunktion $h_R(n)$ (siehe Gleichung 8b), welche mittels zumindest einer Approximationsfunktion $\varphi_k$ und einer Anzahl R von Rekonstruktionszeitpunkten $t_R$ bestimmt wird, zur Ausbildung einer Rekonstruktionswertfolge $z(n)$, welche zu jedem vorbestimmten Rekonstruktionszeitpunkt $t_R$ einen Rekonstruktionswert aufweist, filtert.

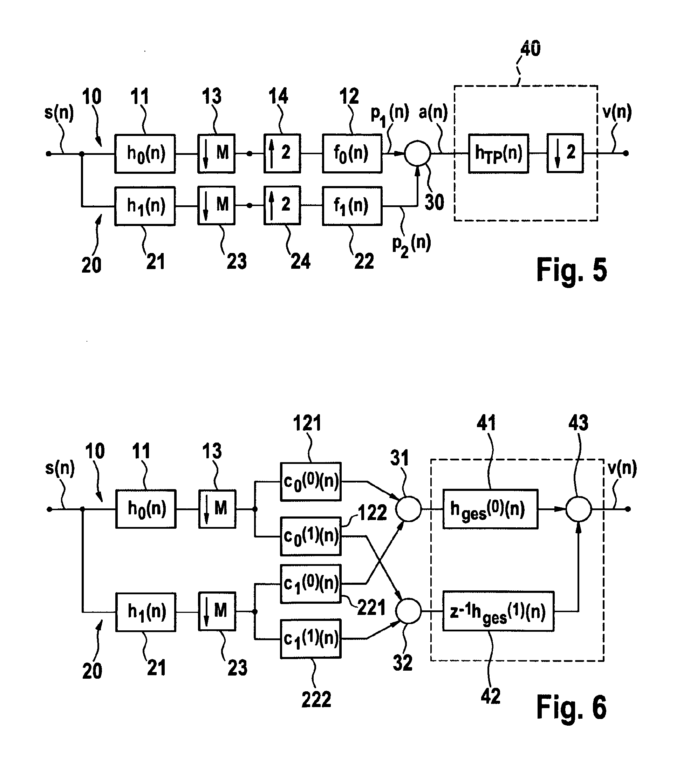

Fig. 5 zeigt ein schematisches Blockdiagramm eines zweiten Ausführungsbeispiels der erfindungsgemäßen Vorrichtung. Hier ist der Faktor K für die Aufwärtstastereinheit 14, 24 des ersten Filterpfades 10 bzw. des zweiten Filterpfades 20 gleich 2 gewählt. Des Weiteren ist die Anzahl R vorbestimmter Rekonstruktionszeitpunkte pro Zeitintervall $T_m$ ebenfalls gleich 2 gewählt (R = 2), so dass sich der Quotient aus R und K als 1 ergibt. Außerdem ist die Rekonstruktionsfilterfunktion $h_R(n)$ der Rekonstruktionsfiltervorrichtung 40 als eine Tiefpass-Filterfunktion $h_{TP}(n)$ ausgebildet. Nach dieser Tiefpassfilterung wird die Abtastrate mittels eines Abschlussfilters 50 auf $1/T_M$ zur Ausbildung einer Ausgangswertfolge $v(n)$ reduziert.

Die Filterfunktionen $f_0(n)$, $f_1(n)$ werden jeweils in einen ersten Teil $c_0(n)$, $c_1(n)$, der für die jeweilige Filterfunktion $f_0(n)$, $f_1(n)$ spezifisch ist, und in einen zweiten Teil $d(n)$, den alle Filterfunktionen $f_0(n)$, $f_1(n)$ aufweisen, aufgeteilt (siehe Gleichung 13a):

$$f_0(n) = c_0(n) \, {}^*d(n) \tag{13a}$$

$$f_1(n) = c_1(n) \, {}^*d(n) \tag{13a}$$

Außerdem wird die Gesamttiefpass-Filterfunktion $h_{ges}$ mittels einer Faltung aus der Tiefpass-Filterfunktion $h_{TP}(n)$ und dem zweiten Teil $t(n)$ der Filterfunktionen $f_0(n)$ $f_1(n)$ bereitgestellt (siehe Gleichung 13b).

$$h_{ges} = h_{TP}(n) \, {}^*d(n) \tag{13b}$$

Ferner werden der erste Teil $c_0(n)$, der zweite Teil $c_1(n)$ und die Gesamttiefpass-Filterfunktion $h_{ges}(n)$ jeweils in eine Anzahl N ihrer Polyphasenkomponenten $c_0^{(0)}(n)$, $c_0^{(1)}(n)$; $c_1^{(0)}(n)$, $c_1^{(1)}(n)$; $h_{ges}^{(0)}(n)$, $h_{ges}^{(1)}(n)$ aufgeteilt (siehe Gleichung 14):

$$c_0^{(0)}(n) = c_0(2n) \tag{14}$$
$$c_0^{(1)}(n) = c_0(2n + 1)$$

In Fig. 6 ist ein schematisches Blockschaltbild eines dritten Ausführungsbeispiels der erfindungsgemäßen Vorrichtung dargestellt. Das dritte Ausführungsbeispiel der erfindungsgemäßen Vorrichtung gemäß Fig. 6 nutzt die in den obenstehenden Gleichungen 13a, 13b und 14 dargestellten Bedingungen.

Gemäß Fig. 6 weist die zweite Filtervorrichtung 12, 22 eine Anzahl N an Filtereinheiten 121, 122; 221, 222 auf, wobei die jeweilige n-te Filtereinheit 121, 122; 221, 222, mit $n \in [0,...,N-1]$, die gefilterte Abtastwertfolge b(n) mittels der n-ten Polyphasenkomponente $c_0^{(n)}$, $c_1^{(n)}$ des ersten Teils $c_0$, $c_1$ filtert. Nachdem K = 2 gewählt ist, ergibt sich N = 2. Demgemäß weist die Überlagerungsvorrichtung 30 eine erste Überlagerungseinheit 31 zur Überlagerung von $c_0^{(0)}(n)$ und $c_1^{(0)}(n)$ und eine zweite Überlagerungseinheit 32 zur Überlagerung von $c_0^{(1)}(n)$ und $c_1^{(1)}(n)$ auf. Weiter weist die Rekonstruktionsfiltervorrichtung 40 die Anzahl N an Rekonstruktionsfiltereinheiten 41, 42 auf, wobei die jeweilige n-te Rekonstruktionsfiltereinheit 41, 42 die Ausgänge der n-ten Filtereinheiten 121, 122; 221, 222 mittels der n-ten Polyphasenkomponente $h_{ges}^{(0)}(n)$, $h_{ges}^{(1)}(n)$ der Gesamttiefpass-Filterfunktion $h_{ges}(n)$ filtert. Weiter weist die n-te Rekonstruktionsfiltereinheit 41, 42 ein vorgeschaltetes Zeitglied auf, das die Filterung mittels der n-ten Polyphasenkomponente $h_{ges}^{(0)}(n)$, $h_{ges}^{(1)}(n)$ der Gesamttiefpass-Filterfunktion $h_{ges}(n)$ um n Zeiteinheiten verzögert.

Obwohl die vorliegende Erfindung vorstehend anhand bevorzugter Ausführungsbeispiele beschrieben wurde, ist sie darauf nicht beschränkt, sondern auf vielfältige Weise modifizierbar. So ist im Besonderen die Auswahl der Approximationsfunktionen vom Entwickler hinsichtlich der jeweiligen Problemstellung wählbar. Ebenso wird in obiger Beschreibung an verschiedenen Stellen auf ein Multiplexsystem Bezug genommen, in dem analoge Signal nur zu begrenzten, periodisch wiederkehrenden Zeiten beobachtbar sind. Diese analogen Signale treten jedoch auch in anderen Systemen auf. Hierbei stehen die Begriffe "Multiplexrate" und "Multiplexperiode" synonym für die Rate der Wiederkehr bzw. die Periode der periodisch wiederkehrenden Beobachtungszeiträume.

## Patentansprüche

1. Verfahren zur echtzeitfaltigen Rekonstruktion eines nicht-äquidistant abgetasteten, analogen Signals (s(t)), welches nur zu begrenzten, periodisch mit der Periodendauer $T_M$ wiederkehrenden Zeitintervallen beobachtbar ist, mit den folgenden Schritten:

   a) Bereitstellen einer ganzzahligen Anzahl K an vorbestimmten Approximationsfullktionen ($\varphi_k$), mit $k \in [0,...,K-1]$, an vorbestimmten Abtastzeitpunkten (t), wobei in jedem Zeitintervall ($T_M$) eine Anzahl M an vorbestimmten Abtastzeitpunkten (t) vorgesehen wird;
   b) nicht-äquidistantes Abtasten des Signals (s(t)) an den vorbestimmten Abtastzeitpunkten (t) zur Ausbildung einer Abtastwerfolge (s(n));
   c) Bereitstellen einer Anzahl K von Filterpfaden (10, 20) und K Filterfunktionen ($f_k(n)$), wobei jeweils in dem k-ten Filterpfad (10, 20) die folgenden Schritte durchgeführt werden:

      c1) Filtern der Abtastwertfolge (s(n)) mittels einer von der k-ten Approximationsfunktion ($\varphi_k$) abhängigen k-ten Impulsantwort ($h_k(n)$) zur Bereitstellung einer gefilterten Abtastwertfolge (b(n)), und
      c2) Filtern der gefilterten Abtastwertfolge (b(n)) mittels der k-ten Filterfunktion ($f_k(n)$) zur Bereitstellung einer k-ten Filterpfadausgangsfolge ($p_k(n)$), wobei die k-te Filterfunktion ($f_k(n)$) in Abhängigkeit von dem k-ten Impulsantworten ($h_k(n)$) bestimmt wird;

   d) Überlagern der K Filterpfadansgangsfolgen ($p_k(n)$) zur Ausbildung einer Gewichtungswertfolge (a(n)); und
   e) Filtern der Gewichtungswertfulge (a(n)) mittels einer Rekonstruktionsfilterfunktion ($h_R(n)$), welche mittels zumindest einer der vorbestimmten Approximationsfunktionen ($\varphi_k$) und einer Anzahl R von Rekonstruktionszeitpunkten ($t_R$) bestimmt wird, zur Ausbildung einer Rekonstruktionswertfolge (z(n)), welche zu jedem vorbestimmten Rekonstroktionszeitpunkt ($t_R$) einen Rekonstruktionswert aufweist,

   **dadurch gekennzeichnet,**
   **dass** zur Bestimmung für jede der Filterfunktionen ($f_k(n)$) eine Vielzahl von ersten Hilfsfolgen ($\alpha$) berechnet wird, wobei eine der ersten Hilfsfolgen ($\alpha$) der Vielzahl von ersten Hilfsfolgen ($\alpha$) aus einer Faltung zumindest zweier unterschiedlicher oder zweier identischer der Impulsantworten ($h_k(n)$) berechnet wird.

2. Verfahren nach Anspruch 1,
   **dadurch gekennzeichnet,**
   **dass** zur Bestimmung der K Filterfunktion ($f_k(n)$) eine Vielzahl von zweiten Hilfsfolgen (g(n)) bestimmt wird, wobei eine zweite Hilfsfolge (g(n)) in Abhängigkeit des Faktors M und zumindest einer ersten Hilfsfolge ($\alpha(n)$) bestimmt wird.

3. Verfahren nach Anspruch 2,
   **dadurch gekennzeichnet,**

**dass** die K Filterfunktionen ($f_k(n)$) mittels eines Perfekte-Rekonstruktions-Verfahrens aus den zweiten Hilfsfolgen ($g(n)$) bestimmt werden.

4. Verfahren nach Anspruch 3,
   **dadurch gekennzeichnet,**
   **dass** das Perfekte-Rekonstruktion-Verfahren mittels einer Toleranzfunktion mit einem vorbestimmten Toleranzbereich versehen wird.

5. Verfahren nach einem oder mehreren der bevorstehenden Ansprüche,
   **dadurch gekennzeichnet,**
   **dass** die Rekonstruktionsfilterfunktion ($h_R(n)$) als eine Tiefpass-Filterfunktion ($h_{TP}(n)$) ausgebildet ist.

6. Verfahren nach einem oder mehreren der bevorstehenden Ansprüche,
   **dadurch gekennzeichnet,**
   **dass** die Filterfunktionen ($f_0(n)$, $f_1(n)$) jeweils in einen ersten Teil ($c_0(n)$, $c_1(n)$), der für die jeweilige Filterfunktion ($f_0(n)$, $f_1(n)$) spezifisch ist, und in einen zweiten Teil ($d(n)$), den alle Filterfunktionen ($f_0(n)$, $f_1(n)$) aufweisen, aufgeteilt werden.

7. Verfahren nach Anspruch 6,
   **dadurch gekennzeichnet,**
   **dass** eine Gesamttiefpass-Filterfunktion ($h_{ges}$) mittels einer Faltung aus der Tiefpass-Filterfunkion ($h_{TP}(n)$) und dem zweiten Teil ($d(n)$) der Filterfunktionen ($f_0(n)$, $f_1(n)$) bereitgestellt wird.

8. Verfahren nach Anspruch 7,
   **dadurch gekennzeichnet,**
   **dass** der erste Teil ($c_0(n)$), der zweite Teil ($c_1(n)$) und die Gesamttiefpass-Filterfunktion ($h_{ges}(n)$) jeweils in eine Anzahl N ihrer Polyphasenkomponenten ($c_0^{(0)}(n)$, $c_0^{(1)}(n)$; $c_1^{(0)}(n)$, $c_1^{(1)}(n)$; $h_{ges}^{(0)}(n)$, $h_{ges}^{(1)}(n)$) aufgeteilt werden.

9. Verfahren nach einem oder mehreren der bevorstehenden Ansprüche;
   **dadurch gekennzeichnet,**
   **dass** zwischen dem Filtern mittels der k-ten Impulsantwort ($h_k(n)$) und dem Filtern mittels der k-ten Filterfunktion ($f_k(n)$) folgende Schritte durchgeführt werden:

   - Dezimieren einer Rate der gefilterten Abtastwertfolge um den Faktor M; und
   - Erhöhen der Rate der gefilterten Abtastwertfolge ($b(n)$) um den Faktor K.

10. Verfahren nach einem oder mehreren der bevorstehenden Ansprüche,
    **dadurch gekennzeichnet,**
    **dass** die Approximationsfunktion ($\varphi_k$) als B-Splines, als eine hermetische Funktion oder als eine von einer Si-Funktion abgeleiteten Funktion ausgebildet wird.

11. Verfahren nach einem oder mehreren der bevorstehenden Ansprüche,
    **dadurch gekennzeichnet,**
    **dass** die Abtastzeitpunkte ($t$) innerhalb eines Zeitintervalls ($T_M$) und/oder die Rekonstruktionszeitpunkte ($t_R$) äquidistant gewählt werden.

12. Vorrichtung zur Durchführung eines Verfahrens nach einem order mehreren der vorstehenden Ansprüche zur echtzeitfähigen Rekonstruktion eines nicht-äquidistant abgetasteten, analogen Signals ($s(t)$), welches nur zu begrenzten, periodisch mit der Periodendauer $T_M$ wiederkehrenden Zeitintervallen beobachtbar ist, mit:

    a) ersten Mitteln, welche eine ganzzahlige Anzahl K an vorbestimmten Approximationsfunktionen ($\varphi_k$), mit $k \in [0,---,K-1]$, an vorbestimmten Abtastzeitpunkten ($t$) bereitstellen, wobei in jedem Zeitintervall ($T_M$) eine Anzahl M an vorbestimmten Abtastzeitpunkten ($t$) vorgesehen ist;
    b) einer Abtastvorrichtung, welche das Signal ($s(t)$) an den vorbestimmten Abtastzeitpunkten ($t$) zur Ausbildung einer Abtastwertfolge ($s(n)$) abtastet;
    c) einer Anzahl K von Filterpfaden (10, 20) und K Filterfunktionen ($f_k(n)$), wobei jeweils der k-te Filterpfad (10, 20) aufweist:

c1) eine erste Filtervorrichtung (11, 21), welche die Abtastwertfolge (s(n)) mittels einer von der k-ten Approximationsfunktion ($\varphi_k$) abhängigen k-ten Impulsantwort ($h_k(n)$) zur Bereitstellung einer gefilterten Abtastwertfolge (b(n)) filtert; und

c2) eine zweite Filtervorrichtung (12, 22), welche die gefilterte Abtastwertfolge (b(n)) mittels der k-ten Filterfunktion ($f_k(n)$) zur Bereitstellung einer k-ten Filterpfadausgangsfolge ($p_k(n)$) filtert, wobei die k-teFilterfunktion ($f_k(n)$) in Abhängigkeit von dem k-ten Impulsantworten ($h_k(n)$) bestimmt wird;

d) eine Überlagerungsvorrichtung (30), welche die K Filterpfadausgangsfolgen ($p_k(n)$) zur Ausbildung einer Gewichtungswertfolge (a(n)) überlagert; und

e) eine Rekonstruktionsflltervorrichtung (40), welche die Gewichtungswertfolge (a(n)) mittels einer Rekonstruktionsfilterfunktion ($h_R(n)$), welche mittels zumindest einer der vorbestimmten Approximationsfunktionen ($\varphi_k$) und einer Anzahl R von Rekonstrutktionszeitpunkten ($t_R$) bestimmt wird, zur Ausbildung einer Rekonstruktionswertfolge (z(n)), welche zu jedem vorbestimmten Rekonstruktionszeitpunkt ($t_R$) einen Rekonstruktionswert aufweist, filtert,

**dadurch gekennzeichnet,**
**dass** zur Bestimmung für jede der Filterfunktionen ($f_k(n)$) eine Vielzahl von ersten Hilfsfolgen ($\alpha$) berechnet wird, wobei eine der ersten Hilfsfolgen ($\alpha$) der Vielzahl von ersten Hilfsfolgen ($\alpha$) aus einer Faltung zumindest zweier unterschiedlicher oder zweier identischer dem k-ten Impulsantworten ($h_k(n)$) berechnet wird.

**13.** Vorrichtung nach Anspruch 12,
**dadurch gekennzeichnet,**
**dass** die zweite Filtervorrichtung (12, 22) eine Anzahl N an Filtereinheiten (121, 122; 221, 222) aufweist, wobei die jeweilige n-te Filtereinheit (121, 122; 221, 222), mit $n \in [0,...,N-1]$, die gefilterte Abtastwertfolge (b(n)) mittels einer n-ten Polyphasenkumponente ($c_0^{(n)}$, $c_1^{(n)}$) eines ersten Teils ($c_0, c_1$) filtert, wobei der erste Teil ($c_0, c_1$) ein für die jeweilige Filterfunktion ($f_k(n)$) spezifischer Teil der Filterfunktion ($f_k(n)$) ist.

**14.** Vorrichtung nach Anspruch 13,
**dadurch gekennzeichnet,**
**dass** die Rekonstruktionsfilervorrichtung (40) die Anzahl N an Rekonstruktionsfiltereinheiten (41, 42) aufweist, wobei die jeweilige n-te Rekonstruktionsfiltereinheit (41, 42) die Ausgänge der n-ten Filtereinheiten (121, 122; 221, 222) mittels einer n-ten Polyphasenkomponenten ($h_{ges}^{(0)}(n), h_{ges}^{(1)}(n)$) der Gesamttiefpass-Filterfunktion ($h_{ges}(n)$) filtert.

**15.** Vorrichtung nach Anspruch 14,
**dadurch gekennzeichnet,**
**dass** die n-te Rekonstruktionsfiltereinheit (41, 42) ein vorgeschaltetes Zeitglied aufweist, welches die Filterung mittels der n-ten Polyphasenkomponente ($h_{ges}^{(0)}(n)$, $h_{ges}^{(1)}(n)$) der Gesamttiefpass-Filterfunktion ($h_{ges}(n)$) um n Zeiteinheiten verzögert.

**16.** Vorrichtung nach einem oder mehreren der Ansprüche 12 bis 15,
**dadurch gekennzeichnet,**
**dass** der k-te Filterpfad (10, 20) eine Dezimationscienheit (13, 23) und eine Aufwärtstastereinheit (14, 24) aufweist, wobei die Dezimationseinheit (13, 23) die Rate der gefilterten Abtastwertfolge um den Faktor M dezimiert und die Aufwärtstastereinheit (14, 24) die Rate der gefilterten Abtastwertfolge (b(n)) um den Faktor K erhöht.

## Claims

**1.** Method for a real-time reconstruction of a nonuniformly sampled analogue signal (s(t)), which can only be observed at limited time intervals that periodically return with the period duration of $T_M$, comprising the following steps:

a) providing an integer number K of predetermined approximation functions ($\varphi_k$), with $k \in [0,...,K-1]$, at predetermined sampling times (t), with a number M of predetermined sampling times (t) being provided in each time interval ($T_M$) ;

b) nonuniformly sampling the signal (s(t)) at the predetermined sampling times (t) in order to form a sampled-value sequence (s(n));

c) providing a number K of filter paths (10, 20) and K filter functions ($f_k(n)$), with the following steps respectively being carried out in the k-th filter path (10, 20):

c1) filtering the sampled-value sequence (s(n)) by means of a k-th impulse response ($h_k$(n)) which is dependent on the k-th approximation function ($\varphi_k$) in order to provide a filtered sampled-value sequence (b(n)), and

c2) filtering the filtered sampled-value sequence (b(n)) by means of the k-th filter function ($f_k$(n)) in order to provide a k-th filter path output sequence ($p_k$(n)), with the k-th filter function ($f_k$(n)) being determined dependent on the k-th impulse responses ($h_k$(n));

d) superposing the K filter path output sequences ($p_k$(n)) in order to form a weighting-value sequence (a(n)); and

e) filtering the weighting-value sequence (a(n)) by means of a reconstruction filter function ($h_R$(n)), which is determined by means of at least one of the predetermined approximation functions ($\varphi_k$) and a number R of reconstruction times ($t_R$), in order to form a reconstruction-value sequence (z(n)), which has a reconstruction value at each predetermined reconstruction time ($t_R$),

**characterized**

**in that** a multiplicity of first auxiliary sequences ($\alpha$) are calculated in order to determine each of the filter functions ($f_k$(n)), with one of the first auxiliary sequences ($\alpha$) of the multiplicity of first auxiliary sequences ($\alpha$) being calculated from a convolution of at least two different or two identical ones of the K impulse responses ($h_k$(n)).

2.  Method according to Claim 1,
    **characterized**
    **in that** a multiplicity of second auxiliary sequences (g(n)) are determined in order to determine the K filter functions ($f_k$(n)), with a second auxiliary sequence (g(n)) being determined dependent on the factor M and at least one first auxiliary sequence ($\alpha$(n)).

3.  Method according to Claim 2,
    **characterized**
    **in that** the K filter functions ($f_k$(n)) are determined from the second auxiliary sequences (g(n)) by means of a perfect-reconstruction method.

4.  Method according to Claim 3,
    **characterized**
    **in that** the perfect-reconstruction method is provided with a predetermined tolerance range by means of a tolerance function.

5.  Method according to one or more of the preceding claims,
    **characterized**
    **in that** the reconstruction filter function ($h_R$(n)) is embodied as a low-pass filter function ($h_{TP}$(n)).

6.  Method according to one or more of the preceding claims,
    **characterized**
    **in that** the filter functions ($f_0$(n), $f_1$(n)) are each subdivided into a first part ($c_0$(n), $c_1$(n)) which is specific to the respective filter function ($f_0$(n), $f_1$(n)) and into a second part (d(n)) which is common to all filter functions ($f_0$(n), $f_1$(n)).

7.  Method according to Claim 6,
    **characterized**
    **in that** an overall low-pass filter function ($h_{ges}$) is provided by means of a convolution of the low-pass filter function ($h_{TP}$(n)) and the second part (d(n)) of the filter functions ($f_0$(n), $f_1$(n)).

8.  Method according to Claim 7,
    **characterized**
    **in that** the first part ($c_0$(n)), the second part ($c_1$(n)) and the overall low-pass filter function ($h_{ges}$(n)) are each subdivided into a number N of the polyphase components ($c_0^{(0)}$(n), $c_0^{(1)}$(n) ; $c_1^{(0)}$(n), $c_1^{(1)}$(n) ; $h_{ges}^{(0)}$(n), $h_{ges}^{(1)}$(n)) thereof.

9.  Method according to one or more of the preceding claims,
    **characterized**
    **in that** the following steps are carried out between filtering by means of the k-th impulse response ($h_k$(n)) and filtering by means of the k-th filter function ($f_k$(n)) :

- reducing a rate of the filtered sampled-value sequence by the factor M; and
- increasing the rate of the filtered sampled-value sequence (b(n)) by the factor K.

**10.** Method according to one or more of the preceding claims, **characterized in that** the approximation function ($\varphi_k$) is embodied as B-spline, as a Hermite function or as a function derived from a sinc function.

**11.** Method according to one or more of the preceding claims, **characterized in that** the sampling times (t) within a time interval ($T_M$) and/or the reconstruction times ($t_R$) are selected to be uniform.

**12.** Device for carrying out a method according to one or more of the preceding claims, for a real-time reconstruction of a nonuniformly sampled analogue signal (s(t)), which can only be observed at limited time intervals that periodically return with the period duration of $T_M$, comprising:

a) first means which provide an integer number K of predetermined approximation functions ($\varphi_k$), with $k \in [0,...,$ K-1], at predetermined sampling times (t), with a number M of predetermined sampling times (t) being provided in each time interval ($T_M$) ;

b) a sampling device, which samples the signal (s(t)) at the predetermined sampling times (t) in order to form a sampled-value sequence (s(n));

c) a number K of filter paths (10, 20) and K filter functions ($f_k(n)$), with the k-th filter path (10, 20) respectively having:

c1) a first filter device (11, 21), which filters the sampled-value sequence (s(n)) by means of a k-th impulse response ($h_k(n)$) which is dependent on the k-th approximation function ($\varphi_k$) in order to provide a filtered sampled-value sequence (b(n)), and

c2) a second filter device, which filters the filtered sampled-value sequence (b(n)) by means of the k-th filter function ($f_k(n)$) in order to provide a k-th filter path output sequence ($p_k(n)$), with the k-th filter function ($f_k(n)$) being determined dependent on the k-th impulse responses ($h_k(n)$);

d) a superposition device (30), which superposes the K filter path output sequences ($p_k(n)$) in order to form a weighting-value sequence (a(n)); and

e) a reconstruction filter device (40), which filters the weighting-value sequence (a(n)) by means of a reconstruction filter function ($h_R(n)$), which is determined by means of at least one of the predetermined approximation functions ($\varphi_k$) and a number R of reconstruction times ($t_R$), in order to form a reconstruction-value sequence (z(n)), which has a reconstruction value at each predetermined reconstruction time ($t_R$),

**characterized in that** a multiplicity of first auxiliary sequences ($\alpha$) are calculated in order to determine each of the filter functions ($f_k(n)$), with one of the first auxiliary sequences ($\alpha$) of the multiplicity of first auxiliary sequences ($\alpha$) being calculated from a convolution of at least two different or two identical ones of the K impulse responses ($h_k(n)$).

**13.** Device according to Claim 12, **characterized in that** the second filter device (12, 22) has a number N of filter units (121, 122; 221, 222), with the respective n-th filter unit (121, 122; 221, 222), with $n \in [0,...,N-1]$, filtering the filtered sampled-value sequence (b(n)) by means of an n-th polyphase component ($c_0^{(n)}$ , $c_1^{(n)}$) of a first part ($c_0$, $c_1$), with the first part ($c_0$, $c_1$) being part of the filter function ($f_k(n)$) that is specific to the respective filter function ($f_k(n)$).

**14.** Device according to Claim 13, **characterized in that** the reconstruction filter device (40) has the number N of reconstruction filter units (41, 42), with the respective n-th reconstruction filter unit (41, 42) filtering the outputs of the n-th filter units (121, 122; 221, 222) by means of an n-th polyphase component ($h_{ges}^{(0)}(n)$, $h_{ges}^{(1)}(n)$) of the overall low-pass filter function ($h_{ges}(n)$).

**15.** Device according to Claim 14, **characterized in that** the n-th reconstruction filter unit (41, 42) has an upstream time member, which delays the filtering by means of the n-th polyphase component ($h_{ges}^{(0)}(n)$, $h_{ges}^{(1)}(n)$) of the overall low-pass filter function ($h_{ges}(n)$) by n time units.

16. Device according to one or more of Claims 12 to 15,
**characterized**
**in that** the k-th filter path (10, 20) has a reduction unit (13, 23) and an upward sampling unit (14, 24), with the reduction unit (13, 23) reducing the rate of the filtered sampled-value sequence by the factor M and the upward sampling unit (14, 24) increasing the rate of the filtered sampled-value sequence ($b(n)$) by the factor K.

## Revendications

1. Procédé de reconstruction en temps réel d'un signal analogique ($s(t)$) échantillonné de manière non équidistante et qui ne peut être observé que dans des intervalles de temps limités qui se répètent périodiquement à une période $T_M$, le procédé présentant les étapes suivantes :

   a) prévoir un nombre entier K de fonctions prédéterminées d'approximation ($\varphi_k$) avec $k \in [0,..., K-1]$ en des instants d'échantillonnage ($t$) prédéterminés, un nombre M d'instants prédéterminés d'échantillonnage ($t$) étant prévu dans chaque intervalle de temps ($T_M$),
   b) échantillonner de manière non équidistante le signal ($s(t)$) aux instants prédéterminés d'échantillonnage ($t$) de manière à former une succession ($s(n)$) de valeurs d'échantillonnage,
   c) prévoir un nombre K de parcours de filtrage (10, 20) et un nombre K de fonctions de filtrage ($f_k(n)$), les étapes suivantes étant exécutées dans chacun des k parcours de filtrage (10, 20) :

      c1) filtrage de la succession ($s(n)$) de valeurs d'échantillonnage au moyen d'une k-ème réponse impulsionnelle ($h_k(n)$) qui dépend de la k-ème fonction d'approximation ($\varphi_k$) pour délivrer une succession ($b(n)$) de valeurs d'échantillonnage filtrées et
      c2) filtrer la succession ($b(n)$) de valeurs d'échantillonnage filtrées au moyen de la k-ème fonction de filtrage ($f_k(n)$) en vue de délivrer une k-ème succession de sorties ($p_k(n)$) de parcours de filtrage, la k-ème fonction de filtrage ($f_k(n)$) étant déterminée en fonction de la k-ème réponse impulsionnelle ($h_k(n)$),

   d) superposer les K successions de sorties ($p_k(n)$) de parcours de filtrage pour former une succession ($a(n)$) de valeurs pondérées et
   e) filtrer la succession ($a(n)$) de valeurs pondérées au moyen d'une fonction ($h_R(n)$) de filtrage de reconstruction qui est déterminée au moyen d'au moins une des fonctions prédéterminées d'approximation ($\varphi_k$) et d'un nombre R d'instants ($t_R$) de reconstruction pour former une succession ($z(n)$) de valeurs de reconstruction qui présentent une valeur de reconstruction à chaque instant prédéterminé de reconstruction ($t_R$),

   **caractérisé en ce que**
   plusieurs premières successions auxiliaires ($\alpha$) sont calculées pour déterminer chacune des fonctions de filtrage ($f_k(n)$), une des premières successions auxiliaires ($\alpha$) des différentes premières successions auxiliaires ($\alpha$) étant calculée à partir d'une convolution d'au moins deux réponses impulsionnelles différentes ou de deux réponses impulsionnelles identiques des K réponses impulsionelles ($h_k(n)$).

2. Procédé selon la revendication 1, **caractérisé en ce que** plusieurs deuxièmes successions auxiliaires ($g(n)$) sont déterminées pour déterminer les fonctions de filtrage K ($f_k(n)$), une deuxième succession auxiliaire ($g(n)$) étant déterminée en fonction du facteur M et d'au moins une première succession auxiliaire ($\alpha(n)$).

3. Procédé selon la revendication 2, **caractérisé en ce que** les K fonctions de filtrage ($f_k(n)$) sont déterminées au moyen d'un procédé de reconstruction parfaite des deuxièmes successions auxiliaires ($g(n)$).

4. Procédé selon la revendication 3, **caractérisé en ce que** le procédé de reconstruction parfaite est doté d'une fonction de tolérance qui présente une plage de tolérance prédéterminée.

5. Procédé selon l'une ou plusieurs des revendications précédentes, **caractérisé en ce que** la fonction ($h_R(n)$) de filtrage de reconstruction est configurée comme fonction de filtrage passe-bas ($h_{TP}(n)$).

6. Procédé selon l'une ou plusieurs des revendications précédentes, **caractérisé en ce que** les fonctions de filtrage ($f_0(n)$), ($f_1(n)$) sont toutes divisées en une première partie ($c_0(n)$), ($c_1(n)$) qui est spécifique à chaque fonction de

filtrage ($f_0(n,)$, ($f_1(n)$) et en une deuxième partie ($d(n)$) qui présente toutes les fonctions de filtrage ($f_0(n)$), ($f_1(n)$).

7. Procédé selon la revendication 6, **caractérisé en ce qu'**une fonction de filtrage global passe-bas ($h_{ges}$) est préparée au moyen d'une convolution de la fonction de filtrage passe-bas ($h_{TP}(n)$) et de la deuxième partie ($d(n)$) des fonctions de filtrage ($f_0(n)$, $f_1(n)$).

8. Procédé selon la revendication 7, **caractérisé en ce que** la première partie ($c_0(n)$), la deuxième partie ($c_1(n)$) et la fonction globale de filtrage passe-bas ($h_{ges}(n)$) sont toutes divisées en un nombre N de composants polyphasés ($c_0^{(0)}(n)$, $c_0^{(1)}(n)$, $c_1^{(0)}(n)$, $c_1^{(1)}(n)$, $h_{ges}^{(0)}(n)$, $h_{ges}^{(1)}(n)$).

9. Procédé selon l'une ou plusieurs des revendications précédentes, **caractérisé en ce que** les étapes suivantes sont exécutées entre le filtrage au moyen de la k-ème réponse impulsionnelle ($h_k(n)$) et le filtrage au moyen de la k-ème fonction de filtrage ($f_k(n)$) :

   - décimation du facteur M de la cadence de la succession filtrée de valeurs d'échantillonnage et
   - augmentation du facteur K du taux de la succession filtrée de valeurs d'échantillonnage ($b(n)$).

10. Procédé selon l'une ou plusieurs des revendications précédentes, **caractérisé en ce que** la fonction d'approximation ($\varphi_k$) est configurée comme ligature B, comme fonction hermitienne ou comme fonction dérivée d'une fonction Si.

11. Procédé selon l'une ou plusieurs des revendications précédentes, **caractérisé en ce que** les instants d'échantillonnage ($t$) sont sélectionnés en positions équidistantes à l'intérieur d'un intervalle de temps ($T_M$) et/ou des instants de reconstruction ($t_R$).

12. Dispositif en vue de l'exécution d'un procédé selon l'une ou plusieurs des revendications précédentes, pour la reconstruction en temps réel d'un signal analogique ($s(t)$) qui est échantillonné de manière non équidistante et qui ne peut être observé que pendant des intervalles de temps limités qui se répètent périodiquement à une période $T_M$, le dispositif présentant :

   a) des premiers moyens qui délivrent un nombre entier K de fonctions prédéterminées d'approximations ($\varphi_k$) avec $k \in [0,..., K-1]$ en des instants prédéterminés d'échantillonnage ($t$), un nombre M d'instants prédéterminés d'échantillonnage ($t$) étant prévu dans chaque intervalle de temps ($T_M$),
   b) un dispositif d'échantillonnage qui échantillonne le signal ($s(t)$) aux instants prédéterminés d'échantillonnage ($t$) pour former une succession ($s(n)$) de valeurs d'échantillonnage,
   c) un nombre K de parcours de filtrage (10, 20) et K fonctions de filtrage ($f_k(n)$), chacun des K parcours de filtrage (10, 20) présentant :

      c1) un premier dispositif de filtrage (11, 21) qui filtre la succession ($s(n)$) de valeurs d'échantillonnage au moyen d'une k-ème réponse impulsionnelle ($h_k(n)$) qui dépend de la k-ème fonction d'approximation ($\varphi_k$) pour former une succession filtrée ($b(n)$) de valeurs d'échantillonnage et
      c2) un deuxième dispositif de filtrage (12, 22) qui filtre la succession filtrée ($b(n)$) de valeurs d'échantillonnage au moyen de la k-ème fonction de filtrage ($f_k(n)$) pour délivrer une k-ème succession de sorties ($p_k(n)$) de parcours de filtrage, la k-ème fonction de filtrage ($fk(n)$) étant déterminée en fonction de la k-ème réponse impulsionnelle ($h_k(n)$),

   d) un dispositif de superposition (30) qui superpose les K successions ($p_k(n)$) de sorties de filtrage pour former une succession ($a(n)$) de valeurs pondérées et
   e) un dispositif (40) de filtrage de reconstruction qui filtre la succession ($a(n)$) de valeurs pondérées au moyen d'une fonction ($h_R(n)$) de filtrage de reconstruction qui est déterminée au moyen d'au moins l'une des fonctions prédéterminées d'approximation ($\varphi_k$) et d'un nombre R d'instants de reconstruction ($t_R$) pour former une succession ($z(n)$) de valeurs de reconstruction qui présente une valeur de reconstruction à chaque instant prédéterminé de reconstruction ($t_R$),

   **caractérisé en ce que**
   plusieurs premières successions auxiliaires ($\alpha$) sont calculées pour déterminer chacune des fonctions de filtrage ($f_k(n)$), une des premières successions auxiliaires ($\alpha$) des différentes premières successions auxiliaires ($\alpha$) étant calculée à partir d'une convolution d'au moins deux réponses impulsionnelles différentes ou de deux réponses impulsionnelles identiques des K réponses impulsionelles ($h_k(n)$).

**13.** Dispositif selon la revendication 12, **caractérisé en ce que** le deuxième dispositif de filtrage (12, 22) présente un nombre N d'unités de filtrage (121, 122 ; 221, 222), chaque n-ème unité de filtrage (121, 122 ; 221, 222), avec $n \in [0,..., N-1]$, filtrant la succession filtrée (b(n)) de valeurs d'échantillonnage au moyen d'une n-ème composante polyphasée $(c_0^{(n)}, c_1^{(n)})$ d'une première partie $(c_0, c_1)$, la première partie $(c_0, c_1)$ étant une partie de la fonction de filtrage $(f_k(n))$ spécifique à chaque fonction de filtrage $(f_k(n))$.

**14.** Dispositif selon la revendication 13, **caractérisé en ce que** le dispositif (40) de filtrage de reconstruction présente le nombre N d'unités (41, 42) de filtre de reconstruction, chaque n-ème unité (41, 42) de filtre de reconstruction filtrant les sorties des n-èmes unités de filtrage (121, 122 ; 221, 222) au moyen d'une n-ème composante polyphasée $(h_{ges}^{(0)}(n), h_{ges}^{(1)}(n))$ de la fonction globale de filtrage passe-bas $(h_{ges}(n))$.

**15.** Dispositif selon la revendication 14, **caractérisé en ce que** la n-ème unité (41, 42) de filtres de reconstruction présente un organe branché en amont qui ralentit de n unités de temps la filtration au moyen de la n-ème composante polyphasée $(h_{ges}^{(0)}(n), h_{ges}^{(1)}(n))$ de la fonction globale de filtrage passe-bas $(h_{gen}(n))$.

**16.** Dispositif selon l'une ou plusieurs des revendications 12 à 15, **caractérisé en ce que** le k-ème parcours de filtrage (10, 20) présente une unité de décimation (13, 23) et une unité d'échantillonnage avant (14, 24), l'unité de décimation (13, 23) décimant du facteur M la cadence de la succession filtrée de valeurs d'échantillonnage et l'unité (14, 24) d'échantillonnage avant augmentant du facteur K la cadence de la succession filtrée (b(n)) de valeurs d'échantillonnage.

# Fig. 1

## Fig. 2

```
        ┌─────────────────────┐
        │          a          │
        └─────────────────────┘
                   │
                   ▼
        ┌─────────────────────┐
        │          b          │
        └─────────────────────┘
                   │
        ┌──────────┼──────────┐
        │          ▼        c │
        │  ┌───────────────┐  │
        │  │      c1       │  │
        │  └───────────────┘  │
        │          │          │
        │          ▼          │
        │  ┌───────────────┐  │
        │  │      c2       │  │
        │  └───────────────┘  │
        │          │          │
        └──────────┼──────────┘
                   ▼
        ┌─────────────────────┐
        │          d          │
        └─────────────────────┘
                   │
                   ▼
        ┌─────────────────────┐
        │          e          │
        └─────────────────────┘
```

## Fig. 3

## Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Filterbank Reconstruction of Bandlimited Signals from Nonuniform and Generalized Samples. **YONINA C ELDAR et al.** IEEE TRANSACTIONS ON SIGNAL PROCESSING. IEEE SERVICE CENTER, Oktober 2000, vol. 48

- **WENZLER, SELINGER.** Robust reconstruction of nonuniformly sampled signals. *IEEE,* 02. September 2005, vol. 1
- **NORBERT FLIEGE.** Multiraten-Signalverarbeitung: Theorie und Anwendungen. Teubner Verlag, 1993